# EUROPÄISCHE PATENTSCHRIFT

(11) **EP 2 596 409 B1**
(45) Veröffentlichungstag und Bekanntmachung des Hinweises auf die Patenterteilung: **30.08.2017**
(21) Anmeldenummer: 11735968.7
(22) Anmeldetag: 14.07.2011
(51) Int. Cl.: G06F 17/50

(54) **VORRICHTUNG SOWIE VERFAHREN ZUR STEUERUNG EINES PROZESSVERLAUFS BEI DER HERSTELLUNG VON TEILEN**
DEVICE AND METHOD FOR CONTROLLING THE COURSE OF A PROCESS IN THE PRODUCTION OF PARTS
DISPOSITIF ET PROCÉDÉ DE COMMANDE DU DÉROULEMENT D'UN PROCESSUS DE FABRICATION DE PIÈCES

(30) Priorität: 21.07.2010 CH 12012010
(43) Veröffentlichungstag der Anmeldung: 29.05.2013
(73) Patentinhaber: Kistler Holding AG, 8408 Winterthur (CH)
(72) Erfinder: GRUBER, Juan, 8280 Kreuzlingen (CH)
(86) Internationale Anmeldenummer: PCT/CH2011/000164
(87) Internationale Veröffentlichungsnummer: WO 2012/009821

(56) Entgegenhaltungen:
- EP-A1- 2 124 117
- EP-A2- 0 990 966
- EP-A2- 1 342 534
- WO-A1-01/98846
- WO-A1-2008/142386
- WO-A2-02/35304
- US-A1- 2008 161 959
- JÜRGEN SPECK AND JAKOB EINWAG: "Practical and convenient-changing over cross-sanding machines with the touch of a finger", INTERNET CITATION, April 2002 (2002-04), XP002467284, Gefunden im Internet: URL:http://www.automation.siemens.com/down load/internet/cache/3/1305544/p ub/en/weber_kreuzschliff_e.pdf [gefunden am 2008-02-01]
- THEROBOTGEEKNET: "Multi-Touch_Robot_Control_Demo_01.wmv", INTERNET CITATION, 3 February 2010 (2010-02-03), page 1, XP002653715, Retrieved from the Internet: URL:http://www.youtube.com/watch?v=rQxMf1T V_jo [retrieved on 2011-07-27]

## Beschreibung

### Technisches Gebiet

Die Erfindung betrifft eine Vorrichtung für die Steuerung eines Prozessverlaufes bei der Herstellung von Teilen in einem Werkzeug, sowie ein Verfahren zur Steuerung eines Prozessverlaufs mittels einer solchen Vorrichtung.

### Stand der Technik

Bei der Überwachung, Steuerung oder Regelung von Herstellvorgängen, wie zum Beispiel von Spritzgiessmaschinen, Werkzeugmaschinen, Robotersystemen oder dergleichen, ist es bekannt, die Eingabe von Parametern für Überwachungs- und Steuerungsfunktionen mittels numerischer Eingaben an einem Terminal oder durch die Verwendung von Cursortasten über ein Display vorzunehmen.

So geschehen zum Beispiel die Überwachung, die Steuerung und die Regelung von Spritzgiessprozessen mit Hilfe verschiedensten Sensoren. So sind Druck-, Temperatur, Ultraschall- oder anderen Sensoren bekannt, die beispielsweise den Druckverlauf, die Werkzeugwandtemperatur, die Schmelztemperatur eines in einem Prozessverlaufs zu verarbeitenden Werkstoffs oder andere Grössen im Prozessverlauf messen. Die von den Sensoren aufgenommenen Messdaten werden grafisch in Kurvenverläufe, die zum Beispiel die Zeitabhängigkeit der entsprechenden Prozessgrösse repräsentieren, umgesetzt und ausgewertet. Dazu werden beim Spritzgiessen insbesondere für die Prozessgrössen Werkzeuginnendruck und Werkzeugwandtemperatur mehrheitlich Überwachungsfunktionen und Echtzeitschwellen verwendet. Eine Überwachungsfunktion berechnet Kennwerte aus einer oder mehreren Kurven, wie zum Beispiel das Maximum in einem bestimmten Zeitfenster. Diese Kennwerte werden mit vorgegebenen Sollparametern verglichen und je nach dem, ob die Sollparameter eingehalten wurden oder nicht, wird eine definierte Aktion ausgelöst.

Beispiele für Überwachungsfunktionen beim Spritzgiessen sind "Box Eintritt-Austritt", "Box No Entry", "Maximum", "Minimum", "Integral", "Vertikale Schwelle", "Mittelwert", "Hüllkurve" usw..

Eine Echtzeitschwelle führt dabei eine definierte Aktion sofort aus, sobald die festgelegte Schwelle überschritten oder unterschritten wird. Die durch Echtzeitschwellen festgelegten Aktionen sind beispielweise "einen digitalen Ausgang schalten" oder "eine optische Signalisierung auf einem Bildschirm auslösen".

Im Stand der Technik werden dabei die Überwachungsfunktionen und Echtzeitschwellen entweder numerisch eingegeben oder die Grenzen mittels Cursortasten in Form von Hardkeys oder Softkeys auf einem Bildschirm in diskreten Schritten verschoben, bis sie schliesslich da liegen, wo der Benutzer sie haben will. Sie können dabei auf dem Bildschirm in der Kurvenansicht dargestellt werden.

Diese Art der Eingabe bzw. Manipulation der Überwachungsfunktionen und Echtzeitschwellen, die jeweils auch als Evaluationsobjekte bezeichnet werden, ist für den Benutzer wenig intuitiv und verlangt häufig spezielle Kenntnisse, über die nicht alle Benutzer verfügen. Daher ist es notwendig, das Bedienpersonal speziell auszubilden, was zeitaufwendig und teuer ist.

Die US 2008/161959 A1 betrifft ein Herstellverfahren und eine dazugehörige Vorrichtung zum Herstellen von Teilen, wobei der Zustand des Werkzeugs permanent überwacht werden soll und bei Bedarf ein Alarm ausgelöst wird, damit alte Werkzeuge rechtzeitig ersetzt werden können, bevor sie brechen.

In der WO02/35304A2 wird ein Bediengerät mit Datenspeicher und Touchscreen zur benutzerfreundlichen Steuerung einer Heizungsanlage offenbart. Im Datenspeicher lassen sich Sollwerte für die Steuerung der Heizungsanlage speichern und auf dem Touchscreen darstellen.

EP0990966A2 beschreibt eine Spritzgiessmaschine mit einer Vielzahl von Spritzgiessvorrichtungen, einem Computer und einer Mensch-Maschine-Schnittstelle mit Eingabevorrichtung und Bildschirm. Computer und Mensch-Maschine-Schnittstelle kommunizieren über einen bidirektionalen seriellen Bus miteinander. Die Spritzgiessvorrichtungen geben Echtzeit-Feedbacksignale an den Computer aus. Eine Bedienperson erzeugt mit der Eingabevorrichtung der Mensch-Maschine-Schnittstelle Steuersignale. Der Computer empfängt die Eingabesignale und interpretiert in Echtzeit die Eingabesignale und die Echtzeit-Feedbacksignale und stellt Echtzeit-Maschinensteuersignale für die Spritzgiessvorrichtungen und Echtzeit-Anzeigesteuersignale für die Mensch-Maschine-Schnittstelle zur Verfügung.

Therobotgeeknet:"Multi-Toch_Robot_Control_Demo_01.wmc", Internet Citation XP002653715 zeigt einen Roboter, der von einem Computer über Steuersignale angesteuert wird. Eine Übermittlung der Steuersignale erfolgt per Funk. Der Computer weist einen Touchscreen auf, eine Bedienperson erzeugt die Steuersignale durch Berühren des Touchscreens.

### Darstellung der Erfindung

Die Aufgabe der Erfindung ist es daher, eine neuartige Vorrichtung und ein neues Verfahren zur Steuerung eines Prozessverlaufs bei der Herstellung von Teilen in einem Werkzeug mit oder ohne anschliessender Ausschussseparierung zu beschreiben, das nicht mehr die aus dem Stand der Technik bekannten Nachteile aufweist, und insbesondere auch ohne Spezialkenntnisse einfach, intuitiv und flexibel zu bedienen ist.

Die diese Aufgaben lösenden Gegenstände der Erfindung sind durch die Merkmale der unabhängigen Ansprüche gekennzeichnet. Die abhängigen Ansprüche beziehen sich auf besonders vorteilhafte Ausführungsformen der Erfindung.

Die Erfindung betrifft somit eine Vorrichtung für die Steuerung eines Prozessverlaufes bei der Herstellung von Teilen in einem Werkzeug mit oder ohne anschliessender Ausschussseparierung umfassend einen Sensor, der am Werkzeug angebracht ist zur Erfassung von Messwerten während dem Herstellprozess. Als Herstellprozess wird insbesondere auch ein Montageprozess, ein Fügeprozess und jeder andere Prozess verstanden, bis das herzustellende Teil fertig gestellt und bereit zur Auslieferung ist.

Zudem umfasst es eine Datenverarbeitungsanlage umfassend ein Display zum Einlesen und Darstellen der erfassten Messwerte. Die Vorrichtung umfasst weiter ein Ausgabemittel, welches mit der Datenverarbeitungsanlage verbunden ist zum Steuern des Prozessverlaufs. Ein Benutzer kann schliesslich einen oder mehrere Sollparameter in die Datenverarbeitungsanlage eingeben. In der Datenverarbeitungsanlage ist auf Grund einer Analyse dieser Sollparameter und der erfassten Messwerte eine Ausgabegrösse ermittelbar, welche über das Ausgabemittel übertragbar ist zum Steuern eines Prozessverlaufs. Erfindungsgemäss erfolgt die Eingabe des oder der Sollparameter vom Benutzer auf analoge Weise.

Des Weiteren betrifft die Erfindung ein Verfahren zur Steuerung eines Prozessverlaufs mittels einer solchen Vorrichtung.

Die Vorteile dieser Vorrichtung und dieses Verfahrens bestehen darin, dass mittels analoger Eingabe stets eine direkte visuelle Kontrolle der Eingabe erzwungen ist, da die analoge Eingabe gezwungenermassen auf einer visuellen Eingabe basiert. Tippfehler, wie sie bei alphanumerischen Eingaben üblich sind, sind nicht mehr möglich. Zudem ist die Eingabe schneller und bedingt keine speziellen Vorkenntnisse des Bedieners.

### Kurze Beschreibung der Zeichnungen

Im Folgenden wird die Erfindung anhand der Zeichnung näher erläutert. Es zeigt in schematischer Darstellung:

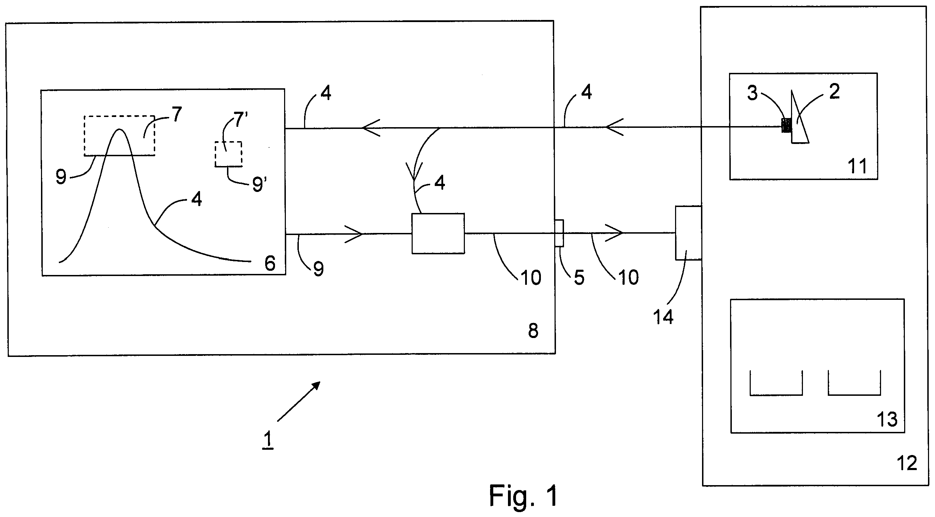

Fig. 1 eine erfindungsgemässe Vorrichtung im Betriebszustand.

### Wege zur Ausführung der Erfindung

Die Fig. 1 zeigt in einer schematischen Darstellung ein Ausführungsbeispiel einer erfindungsgemässen Vorrichtung 1 im Betriebszustand. Die Vorrichtung 1 dient dabei zur Ansteuerung eines Prozessverlaufs in einer Herstellvorrichtung 12, die eine Ausschussseparierung 13 umfassen kann. Die Herstellvorrichtung 12 umfasst ein Werkzeug 11, in dem ein Teil 2 hergestellt ist. Sie ist vorzugsweise eine Spritzgiessmaschine eine Werkzeugmaschine, oder ein Robotersystems.

Insbesondere werden hier zyklische Prozessverläufe betrachtet, welche mit der erfindungsgemässen Vorrichtung resp. durch das erfindungsgemässe Verfahren gesteuert werden sollen.

Die erfindungsgemässe Vorrichtung 1 umfasst einen Sensor 3 zur Erfassung von Messwerten 4 sowie ein Ausgabemittel 5 zum Ansteuern eines Prozessverlaufs in der Herstellvorrichtung 12 oder in der Ausschussseparierung 13. Zudem umfasst die Vorrichtung 1 eine Datenverarbeitungsanlage 8 mit einem Display 6.

Das Ausgabemittel 5 kann insbesondere eine Schnittstelle sein zur Datenausgabe, an dem beispielsweise eine Verbindungsleitung zur Herstellvorrichtung 12, zur Ausschussseparierung 13 oder zu einer zentralen Steuerung 14 für die Herstellung und/oder die Ausschussseparierung angebracht sein kann.

Der Sensor 3 ist im Werkzeug 11 angebracht zur Erfassung von Messwerten 4 während dem Herstellprozess. Für viele Anwendung befindet er sich angrenzend oder sehr nahe an dem herzustellenden Teil 2. In der Regel misst er einen zeitabhängigen Verlauf beispielsweise eines Drucks oder einer Temperatur. Die Messwerte 4 werden in dafür vorgesehenen Verbindungen in die Datenverarbeitungsanlage 8 geleitet und auf dem Display 6 in Form einer Kurve 4 dargestellt.

In die Datenverarbeitungsanlage 8 müssen Sollparameter 9 eingegeben werden, auf Grund derer in einer Analyse zusammen mit den erfassten Messwerten 4 eine Ausgabegrösse 10 ermittelt werden kann. Diese Ausgabegrösse 10 kann beispielsweise die Information enthalten, ob ein hergestelltes Teil ein Gutteil oder ein Ausschussteil ist. Andererseits kann auf Grund der Analyse ein Zeitpunkt festgestellt werden, zum dem ein Prozessschritt im Herstellverfahren begonnen oder beendet werden soll. Die jeweils gewünschte Information ist jeweils in der Ausgabegrösse 10 enthalten. Diese Ausgabegrösse 10 wird schliesslich über das Ausgabemittel 5 zum Steuern des Prozessverlaufs an die Herstellvorrichtung 12, allenfalls an die Ausschussseparierung 13 oder an eine Steuerung 14, weitergeleitet werden. Entsprechend wird anschliessend ein Prozess gemäss der Ausgabegrösse 10 gesteuert. Beispielsweise werden demnach Teile nach Gutteilen und Ausschuss sortiert.

Erfindungsgemäss ist vorgesehen, dass die Sollparameter 9 auf analoge Weise durch den Benutzer einlesbar sind. Der Benutzer gibt demnach keine Zahlenwerte ein, er bedient auch keine Knöpfe, welche vorgegebene Sollwerte in kleinen Schritten bis zur gewünschten Position verschieben. Der Benutzer kann direkt über analoge Bewegungen auf dem Display 6 seine gewünschten Sollwerte 9 festlegen.

Dazu hat er verschiedene Möglichkeiten. Einerseits kann dies beispielsweise mittels Computermaus geschehen, indem er mit einem Cursor beispielsweise ein Rechteck definiert, indem er von einem Eckpunkt eine Diagonale zu einem anderen Eckpunkt zieht. Dasselbe kann er auch an einem Touchscreen erreichen, wenn das Display 6 als ein solcher ausgestaltet ist. Dort zieht er die Diagonale mit einem Finger der mit einem Stift. Auf dem Display 6 können auch bereits ein oder mehrere graphisches Evaluationsobjekte 7' bereit gestellt sein, die einen oder mehrere bereitgestellte Sollparameter 9' repräsentiert. Im vorliegenden Beispiel ist das Evaluationsobjekt 7' durch einen Satz von mehreren Sollparametern 9', die einen rechteckförmigen Bereich zwischen zwei Zeitpunkten und einem minimalem und einem maximalen Sollwert festlegen, definiert. Das Evaluationsobjekt 7' definiert somit in dem hier dargestellten Beispiel auf dem Display 6 einen Bereich, in welchem das Maximum der Messkurve 4 liegen muss, damit das in der Herstellvorrichtung 12 hergestellte Teil 2 den Qualitätsanforderungen genügt und somit kein Ausschuss ist.

Bei der Einrichtung wird das Evaluationsobjekt 7' von einem Bediener auf der Kommunikationsoberfläche 6 an einem vorgegebenen Ort plaziert, in dem das Maximum der Messkurve 4 zu liegen hat. Dazu verschiebt der Bediener das Evaluationsobjekt 7' auf dem Display und ändert dessen Grösse, bis das Evaluationsobjekt 7 auf dem Display 6 am gewünschten Ort und in der gewünschten Grösse ist. Diese Eingabe macht der Benutzer erfindungsgemäss analog. Bequem ist die Eingabe mittels "drag and drop", da so die Rechtecke oder Linien einfach bestimmt und an die gewünschte Stelle verschoben werden können.

Durch die Position des Evaluationsobjekts auf Display 6 legt der Benutzer die Sollparameter 9 fest. Er kann zum Beispiel einen grösseren oder kleineren Zeitbereich definieren, in dem das Maximum der Druckverlaufskurve 4 liegen darf. Ebenso kann auch ein anderer maximaler oder minimaler Wert des zulässigen Drucks definiert werden. Ein anderes Beispiel ist eine vertikale Linie, die beispielsweise ein Zeitpunkt bestimmen kann, an dem ein neuer Prozess gestartet werden soll, beispielsweise ein Umschalten von der Einspritzphase auf die Nachdruckphase beim Spritzgiessen, eine der kritischsten Steuerparameter beim Spritzgiessen.

Da frühere Messwerte oder Messkurven 4 auf dem Display 6 angezeigt sind, fällt es dem Benutzer leicht, die Sollparameter 9 einzugeben. Ist beispielsweise eine Kurvenschar von Messwerten 4 während früher gemessenen Prozesszyklen abgebildet, welche alle zu Gutteilen führten, so kann der Benutzer auf Grund der charakteristischen Gemeinsamkeiten dieser Daten oder Kurven 4 prozessrelevante Sollparameter 9 definieren und diese direkt mit den dargestellten, früheren Messwerten 4 abstimmen. Die Ausgabegrösse 10 wird schliesslich in der Analyse auf Grund dieser Sollparameter 9 und der später erfassten Messwerte 4 ermittelt und zum Ausgabemittel 5 geleitet, wie in Fig. 1 dargestellt.

Auf diese Weise werden die Messwerte 4, also beispielsweise eine Druckverlaufskurve 4, in eine graphische Beziehung zum Evaluationsobjekt 7 gebracht, so dass aus einer Analyse der Messwerte 4 und der Sollparameter 9 eine Ausgabegrösse 10 ermittelbar ist, welche über die Ausgabemittels 5 ausgelesen werden kann zum Steuern eines Prozessverlaufs. Diese Ausgabegrösse kann beispielsweise die Information "Ausschussteil" enthalten, wenn die Messkurve 4 im Sollparameterbereich 9 kein Maximum aufweist.

Ein weiteres Beispiel einer Anwendung ist die Bestimmung des Umschaltpunktes beim Spritzgiessen. Bei vorliegenden Messkurven 4 von Druckkurven beispielsweise, die alle zu Gutteilen geführt haben, kann auf einfache Art vom Benutzer festgelegt werden, wann, das heisst, beim Eintreffen welcher Bedingung, die Nachdruckphase beginnen soll.

Dabei ist es in der Praxis häufig so, dass mehrere Evaluationsobjekte 7 auf der Kommunikationsoberfläche 6 bereit gestellt werden, die verschiedene gewünschte Kurveneigenschaften abtesten können oder auch verschieden geformte Gebiete definieren können, in denen vorgegebene Bereiche einer Messkurve 4 liegen sollen. So können die bereitgestellten Evaluationsobjekte 7' z.B. auch rund oder oval, dreieckförmig, geometrisch unregelmässige Formen oder jede andere gewünschte Form haben, je nach den entsprechenden technischen Anforderungen an die Tests der Kurvenformen. Sie können auch einfache Geraden, Pfeile oder Punkte sein, die gewisse Schwellwerte definieren.

Es versteht sich, dass die Messwerte 4 nicht nur Druckverläufe oder Temperaturverläufe sein können, sondern im Prinzip jede geeignete Grösse, die eine gewünschte Eigenschaft eines Prozessverlaufs geeignet abbildet.

Dabei ist die Anwendung einer erfindungsgemässen Vorrichtung 1 oder eines erfindungsgemässen Verfahrens selbstverständlich nicht auf das aussortieren von Ausschuss beschränkt. So ist es zum Beispiel auch möglich, dass eine bestimmte Prozessgrösse durch ständige Überwachung gesteuert oder geregelt wird.

Im Gegensatz zu vielen Anwendungen aus dem Stand der Technik soll aber keinesfalls eine Regelung erzielt werden, welche einen Kurvenverlauf, beispielsweise eine Heizkurve, nachfahren soll. Im vorliegen Fall geht es, insbesondere beim Steuern einer Ausschusssortieranlage, um Evaluationskriterien, die bei einer Kurve entweder erfüllt sind oder nicht. Der Herstellprozess wird insbesondere nicht während dem Aufnehmen der Kurve überprüft und geregelt, wie dies beim Nachfahren von Sollkurven der Fall ist. Hier wird am Schluss des Herstellprozesses, wenn eine gemessene Kurve 4 vollständig ermittelt ist, diese Kurve 4 Beurteilt und das fertige Teil 2 entsprechend sortiert.

Insbesondere kann ein gesetztes Sollkriterium 9 eine Fläche 7 mit mehreren aneinander angrenzenden Umgrenzungslinien darstellen. Dabei kann festgelegt werden, durch welche der Umgrenzungslinien die Messkurve 4 in die Fläche 7 ein- und/oder austreten muss, damit die Sollkriterien der Sollparameter 9 erfüllt sind. Andererseits können auch Negativkriterien eingegeben werden, indem bestimmt werden kann, dass die Messkurve 4 eine bestimmte Umgrenzungslinie nicht überschreiten darf resp. nicht durch diese in die Fläche 7 ein und/oder aus dieser austreten darf. In der Fig. 1 würde beispielsweise eingegeben werden, dass die Messkurve 4 durch die untere, feste Linie in das Feld 7 ein- und aus diesem wieder dort austreten muss, die anderen, gestrichelten Linien aber in keine Richtung kreuzen darf. So wird ein höheres Maximum der Kurve 4, welches ausserhalb der Fläche 7 liegen würde, die Sollparameter 9 nicht erfüllen, da die obere gestrichelte Linie zweimal durchkreuzt würde. Ebenso wäre ein zu frühes Maximum nicht konform mit den Sollparametern 9, das wohl im Feld 7 liegt, bei dem aber die linke gestrichelte Seite der Fläche 7 von der Messkurve 4 beim Eintritt in die Fläche 7 überquert würde.

Die Felder oder Linien lassen sich leicht intuitiv auf Grund der vorliegenden Messkurven 4 früherer Messungen auf analoge Weise setzen, insbesondere wenn Kurvenscharen 4 von Gutteilen vorliegen, die eine gewisse tolerierbare Streuung aufweisen.

### Bezugszeichenliste

- 1: Vorrichtung
- 2: Teil
- 3: Sensor
- 4: Messwerte
- 5: Ausgabemittel
- 6: Display
- 7: 7' Evaluationsobjekt
- 8: Datenverarbeitungsanlage
- 9: 9' Sollparameter
- 10: Ausgabegrösse
- 11: Werkzeug
- 12: Herstellvorrichtung
- 13: Ausschussseparierung
- 14: Steuerung

## Patentansprüche

1. Vorrichtung für die Steuerung eines Prozessverlaufes bei der Herstellung von Teilen (2) in einem Werkzeug (11) in einer Herstellvorrichtung (12) mit oder ohne anschliessender Ausschussseparierung (13) umfassend einen Sensor (3), der am Werkzeug (11) angebracht ist zur Erfassung von Messwerten (4) während dem Herstellprozess sowie eine Datenverarbeitungsanlage (8) umfassend ein Display (6) zum Einlesen und Darstellen der erfassten Messwerte (4) und ein Ausgabemittel (5), welches mit der Datenverarbeitungsanlage (8) verbunden ist, wobei ein Benutzer einen oder mehrere Sollparameter (9, 9') in die Datenverarbeitungsanlage (8) eingeben kann, und in der Datenverarbeitungsanlage (8) auf Grund einer Analyse dieser Sollparameter (9, 9') und der erfassten Messwerte (4) eine Ausgabegrösse (10) ermittelbar ist, welche über das Ausgabemittel (5) zur Herstellvorrichtung (12) übertragbar ist zum Steuern des Prozessverlaufs, **dadurch gekennzeichnet, dass** der Sensor (3) als Messwerte (4) einen Druckverlauf oder einen Temperaturverlauf erfasst; dass das Display (6) Messwerte (4) in Form einer Kurve darstellt; dass das Display (6) ein Touchscreen ist, auf dem der oder die Sollparameter (9, 9') durch Berühren der Oberfläche analog einlesbar sind; dass der oder die Sollparameter (9, 9') auf analoge Weise durch den Benutzer einlesbar sind; dass auf dem Display (6) ein oder mehrere graphische Evaluationsobjekte (7, 7') bereitgestellt sind, die einen oder mehrere bereitgestellte Sollparameter (9, 9') repräsentieren, welche graphische Evaluationsobjekte (7, 7') durch die Eingabe auf dem Display (6) durch den Benutzer verschiebbar und/oder in ihrer Grösse veränderbar sind; und dass der Benutzer durch eine Position der graphische Evaluationsobjekte (7, 7') auf dem Display (6) die Sollparameter (9, 9') festlegt.

2. Vorrichtung nach Anspruch 1, **dadurch gekennzeichnet, dass** der oder die Sollparameter (9, 9') analog mittels "drag and drop" einlesbar sind.

3. Vorrichtung nach einem der vorangehenden Ansprüche, **dadurch gekennzeichnet, dass** die Herstellvorrichtung (12) eine Spritzgiessmaschine oder eine Werkzeugmaschine oder ein Robotersystem ist.

4. Vorrichtung nach einem der vorangehenden Ansprüche, **dadurch gekennzeichnet, dass** der zu steuernde Prozessverlauf eine Ausschussseparierung ist.

5. Vorrichtung nach einem der vorangehenden Ansprüche, **dadurch gekennzeichnet, dass** der Benutzer die Sollparameter (9, 9') auf Grund von früheren Messwerten (4), die auf dem Display (6) dargestellt sind, in die Datenverarbeitungsanlage eingeben kann.

6. Vorrichtung nach einem der vorangehenden Ansprüche, **dadurch gekennzeichnet, dass** der zu steuernde Prozessverlauf ein zyklischer Prozessverlauf ist.

7. Verfahren zum Steuern eines Prozessverlaufes bei der Herstellung von Teilen (2) in einem Werkzeug (11) in einer Herstellvorrichtung (12) mit oder ohne anschliessender Ausschussseparierung (13) mittels einer Vorrichtung (1), welche einen Sensor (3) umfasst, der am Werkzeug (11) angebracht ist und mit einer Datenverarbeitungsanlage (8) mit einem Display (6) verbunden ist, wobei Messwerte (4) während dem Herstellprozess vom Sensor (3) erfasst, in die Datenverarbeitungsanlage eingelesen und auf dem Display (6) dargestellt werden, wobei die Datenverarbeitungsanlage wiederum mit einem Ausgabemittel (5) verbunden ist, und wobei ein Benutzer einen oder mehrere Sollparameter (9, 9') in die Datenverarbeitungsanlage (8) eingibt, und wobei in der Datenverarbeitungsanlage (8) auf Grund einer Analyse dieser Sollparameter (9, 9') und der erfassten Messwerte (4) eine Ausgabegrösse (10) ermittelt wird, welche über das Ausgabemittel (5) übertragen wird zum Steuern des Prozessverlaufs, **dadurch gekennzeichnet, dass** der Sensor (3) als Messwerte (4) einen Druck oder einen Druckverlauf oder eine Temperatur oder einen Temperaturverlauf erfasst; dass der Display (6) Messwerte (4) in Form einer Kurve darstellt; dass die Eingabe des oder der Sollparameter (9, 9') durch den Benutzer auf analoge Weise erfolgt; dass der Benutzer für die analoge Eingabe der Sollparameter (9, 9') einen Touchscreen durch Berühren der Oberfläche des Displays (6) benutzt; dass auf dem Display (6) ein oder mehrere graphische Evaluationsobjekte (7, 7') bereitgestellt werden, die einen oder mehrere bereitgestellte Sollparameter (9, 9') repräsentieren, wobei der Benutzer zum Einstellen der Sollparameter (9, 9') die auf dem Display (6) bereitgestellte graphische Evaluationsobjekte (7, 7') verschiebt und/oder in ihrer Grösse ändert; und dass der Benutzer durch eine Position der graphische Evaluationsobjekte (7, 7') auf dem Display (6) die Sollparameter (9, 9') festlegt.

8. Verfahren nach Anspruch 7, **dadurch gekennzeichnet, dass** die analoge Eingabe des oder der Sollparameter (9, 9') durch den Benutzer mittels "drag and drop" erfolgt.

9. Verfahren nach einem der vorangehenden Ansprüche, **dadurch gekennzeichnet, dass** der zu steuernde Prozessverlauf eine Ausschussseparierung ist.

10. Verfahren nach einem der Ansprüche 7 bis 9, **dadurch gekennzeichnet, dass** die Teile (2) in einem Werkzeug von einer Spritzgiessmaschine, einer Werkzeugmaschine oder von einem Robotersystem hergestellt werden.

11. Verfahren nach einem der Ansprüche 7 bis 10, **dadurch gekennzeichnet, dass** der Benutzer die Sollwerte (9, 9') auf Grund der auf dem Display (6) dargestellten früheren Messwerte (4) in die Datenverarbeitungsanlage (8) eingibt und die Analyse die Ausgabegrösse (10) auf Grund dieser Sollparameter (9, 9') und der danach erfassten Messwerte (4) ermittelt.

## Claims

1. A device for controlling the course of a process in the production of parts (2) in a tool (11) in a production device (12) with or without subsequent reject separation (13) comprising a sensor (3) fitted to the tool (11) for the detection of measured values (4) during the production process as well as a data processing system (8) that comprises a display (6) for entering and displaying the detected measured values (4), and an output means (5) connected to the data processing system (8) wherein a user can enter one or more target parameters (9, 9') into the data processing system (8) and in said data processing system (8), on the basis of an analysis of these target parameters (9, 9') and the detected measured values (4), an output value (10) can be determined which can be transferred via the output means (5) to the production device (12) for controlling the course of the process, **characterized in that** said measured values (4) detected by the sensor (3) are a pressure course or a temperature course; said display (6) displays measured values (4) in the form of a curve; said display (6) is a touch screen on which the target parameter(s) (9, 9') can be entered in an analogous manner by touching the surface; said target parameter (s) (9, 9') can be entered by a user in an analogous manner; on said display (6) are provided one or more graphical evaluation objects (7, 7') representing one or more target parameter(s) (9, 9') provided, **characterized in that** by said entering the evaluation objects (7, 7') can be moved on the display (6) and/or adjusted in size by a user; and **in that** the user sets said target parameters (9, 9') by a position of the graphical evaluation objects (7, 7') on the display (6).

2. The device according to claim 1, **characterized in that** the target parameter(s) (9, 9') can be entered in an analogous manner by means of "drag and drop".

3. The device according to any of the preceding claims, **characterized in that** the production device (12) is an injection molding machine or a machine tool or a robot system.

4. The device according to any of the preceding claims, **characterized in that** the process course to be controlled is a reject separation.

5. The device according to any of the preceding claims, **characterized in that** the user can enter the target parameters (9, 9') into the data processing system on the basis of prior measured values (4) displayed on the display (6).

6. The device according to any of the preceding claims, **characterized in that** the process to be controlled is a cyclic process.

7. A method for controlling the course of a process in the production of parts (2) in a tool (11) in a production device (12) with or without subsequent reject separation (13) by means of a device (1) that comprises a sensor (3) fitted to the tool (11) and connected to a data processing system (8) having a display, wherein measured values (4) are detected by the sensor (3) during the production process, are entered into the data processing system and displayed on the display (6) wherein said data processing system itself is connected to an output means (5), and wherein a user enters one or more target parameters (9, 9') into the data processing system (8) and wherein in said data processing system (8), on the basis of an analysis of these target parameters (9, 9') and the detected measured values (4), an output value (10) is determined and transferred via the output means (5) for controlling the course of the process, **characterized in that** said measured values (4) detected by the sensor (3) are a pressure or a pressure course or a temperature or temperature course; said display (6) displays measured values (4) in the form of a curve; said entering of the target parameter(s) (9, 9') is performed by the user in an analogous manner; for entering said target parameters (9, 9') in an analogous manner the user uses a touch screen by touching the surface of the display (6); on said display (6) are provided one or more graphical evaluation objects (7, 7') representing one or more target parameter (s) (9, 9') provided, wherein for setting said target parameters (9, 9') the user moves the evaluation objects (7, 7') provided on the display (6) and/or adjusts them in size; and **in that** the user sets the target parameters (9, 9') by a position of the graphical evaluation objects (7, 7') on the display (6).

8. The method according to claim 7, **characterized in that** said entering of the target parameter (s) (9, 9') in an analogous manner is performed by the user by means of "drag and drop".

9. The method according to any of the preceding claims, **characterized in that** the process course to be controlled is a reject separation.

10. The method according to any of the claims 7 to 9, **characterized in that** the parts (2) are produced in a tool of an injection molding machine, a machine tool or by a robot system.

11. The method according to any of the claims 7 to 10, **characterized in that** the user enters the target parameters (9, 9') into the data processing system (8) on the basis of previous measured values (4) displayed on the display (6) and the analysis determines the output value (10) on the basis of these target parameters (9, 9') and the measured values (4) detected afterwards.

## Revendications

1. Un dispositif de commande du déroulement d'un processus de fabrication de pièces (2) dans un outil (11) dans un dispositif de fabrication (12) avec ou sans une séparation des rejets ultérieure, comprenant un capteur (3) monté sur l'outil (11) pour détecter des valeurs de mesure (4) pendant le processus de fabrication ainsi qu'un système de traitement de données (8) comprenant un afficheur (6) pour saisir et représenter les valeurs de mesure (4) détectées et un moyen de sortie (5) relié au système de traitement de données (8), dans lequel un utilisateur peut entrer un ou plusieurs paramètres cible (9, 9') dans le système de traitement de données (8) et dans ledit système de traitement de données (8) une valeur de sortie (10) peut être déterminée sur la base d'une analyse de ces paramètres cible (9, 9') et des valeurs de mesure (4) détectées et peut être transmise par l'intermédiaire du moyen de sortie (5) au dispositif de fabrication (12) pour commander le déroulement du processus, **caractérisé en ce que** ledit capteur (3) détecte comme valeurs de mesure (4) une évolution de la pression ou de la température; ledit afficheur (6) représente des valeurs de mesure (4) sous forme de courbe; l'afficheur (6) est un écran tactile sur lequel le ou les paramètre (s) cible (9, 9') peuvent être entrés par un utilisateur de manière analogique en touchant la surface; un ou plusieurs objets d'analyse graphiques (7, 7') représentant un ou plusieurs paramètres cible (9, 9') sont fournis sur l'afficheur (6), lesdits objets d'analyse graphiques (7, 7'), par la saisie, étant déplaçables sur l'afficheur (6) par un utilisateur et/ou ajustables en taille; et **en ce que** l'utilisateur, par une position des objets d'analyse graphiques (7, 7') sur l'afficheur (6), définit les paramètres cible (9, 9').

2. Le dispositif selon la revendication 1, **caractérisé en ce que** le ou les paramètre (s) cible (9, 9') peuvent être entrés de manière analogique par "glisser/déplacer".

3. Le dispositif selon l'une quelconque des revendications précédentes, **caractérisé en ce que** le dispositif de fabrication (12) est une presse d'injection plastique ou une machine-outil ou un système robotisé.

4. Le dispositif selon l'une quelconque des revendications précédentes, **caractérisé en ce que** le déroulement de processus à contrôler est une séparation des rejets.

5. Le dispositif selon l'une quelconque des revendications précédentes, **caractérisé en ce que** l'utilisateur peut entrer les paramètres cible (9, 9') dans le système de traitement de données sur la base des valeurs de mesures antérieures (4) affichées sur l'afficheur (6).

6. Le dispositif selon l'une quelconque des revendications précédentes, **caractérisé en ce que** ledit processus à contrôler est un processus cyclique.

7. Un procédé de commande du déroulement d'un processus de fabrication de pièces (2) dans un outil (11) dans un dispositif de fabrication (12) avec une séparation des rejets ultérieure ou non, au moyen d'un dispositif (1) comprenant un capteur (3) monté sur l'outil (11) et connecté à un système de traitement de données (8) ayant un afficheur (6), dans lequel des valeurs de mesure (4) sont détectées par le capteur (3) pendant le processus de fabrication, sont entrées dans le système de traitement de données (8) et représentées sur l'afficheur (6), ledit système de traitement de données (8) lui-même étant connecté à un moyen de sortie (5), et dans lequel un utilisateur entre un ou plusieurs paramètres cible (9, 9') dans le système de traitement de données (8) et dans ledit système de traitement de données (8), sur la base d'une analyse de ces paramètres cible (9, 9') et des valeurs de mesure (4) détectées, une valeur de sortie (10) est déterminée et transmise par l'intermédiaire du moyen de sortie (5) pour commander le déroulement du processus, **caractérisé en ce que** ledit capteur (3) détecte comme valeurs de mesure (4) une pression ou une évolution de la pression ou une température ou une évolution de la température; ledit afficheur (6) représente des valeurs de mesure (4) sous forme de courbe; la saisie du ou des paramètre(s) cible (9, 9') se produit par l'utilisateur de manière analogique; pour ladite saisie analogique desdits paramètres cible (9, 9') l'utilisateur utilise un écran tactile en touchant la surface du afficheur (6); un ou plusieurs objets d'analyse graphiques (7, 7') représentant un ou plusieurs paramètres cible (9, 9') sont fournis sur l'afficheur (6), dans lequel pour définir les paramètres cible (9, 9') l'utilisateur déplace lesdits objets d'analyse graphiques (7, 7') fournis sur l'afficheur (6) et/ou en ajuste la taille; et **en ce que** l'utilisateur, par une position des objets d'analyse graphiques (7, 7') sur l'afficheur (6), définit les paramètres cible (9, 9').

8. Le procédé selon la revendication 7, **caractérisé en ce que** ladite saisie analogique du ou des paramètre(s) cible (9, 9') se produit par l'utilisateur par "glisser/déplacer".

9. Le procédé selon l'une quelconque des revendications précédentes, **caractérisé en ce que** le déroulement du processus à contrôler est une séparation des rejets.

10. Le procédé selon l'une quelconque des revendications 7 à 9, **caractérisé en ce que** les pièces (2) sont produites dans un outil d'une presse d'injection plastique ou d'une machine-outil ou par un système robotisé.

11. Le procédé selon l'une quelconque des revendications 7 à 10, **caractérisé en ce que** l'utilisateur entre les paramètres cible (9, 9') dans le système de traitement de données (8) sur la base des valeurs de mesures antérieures (4) affichées sur l'afficheur (6) et l'analyse détermine ladite valeur de sortie (10) sur la base de ces paramètres cible (9, 9') et les valeurs de mesure (4) ultérieurement détectées.
